(19) Europäisches Patentamt
European Patent Office
Office européen des brevets

(11) **EP 4 708 107 A1**

(12) **EUROPEAN PATENT APPLICATION**
published in accordance with Art. 153(4) EPC

(43) Date of publication:
**11.03.2026 Bulletin 2026/11**

(21) Application number: **23935816.1**

(22) Date of filing: **25.09.2023**

(51) International Patent Classification (IPC):
***G06F 30/12*** *(2020.01)* ***G06F 30/392*** *(2020.01)*
***G06F 3/048*** *(2013.01)* ***G06F 9/451*** *(2018.01)*

(52) Cooperative Patent Classification (CPC):
**G06F 30/31; G06F 3/04842; G06F 30/39**

(86) International application number:
**PCT/KR2023/014659**

(87) International publication number:
**WO 2024/228431 (07.11.2024 Gazette 2024/45)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **04.05.2023 KR 20230058395**

(71) Applicant: **POSTECH Research and Business Development Foundation**
**Pohang-si, Gyeongsangbuk-do 37673 (KR)**

(72) Inventors:
- **KIM, Byungsub**
  **Pohang-si, Gyeongsangbuk-do 37673 (KR)**
- **JEONG, Sungyu**
  **Pohang-si, Gyeongsangbuk-do 37673 (KR)**

(74) Representative: **Jung, Minkyu**
**Wuesthoff & Wuesthoff**
**Patentanwälte und Rechtsanwalt PartG mbB**
**Schweigerstraße 2**
**81541 München (DE)**

# (54) USER INTERFACE METHOD OF SEMICONDUCTOR DESIGN PROGRAM, AND COMPUTING DEVICE

(57) Provided is a user interface method of a program for converting a layout of a semiconductor into a generator, the user interface method including displaying, by a terminal performing the program, an interaction button for displaying an interaction to be performed by a user in a layout view and an expression view, the layout view displaying a layout of a semiconductor being converted into a generator, and displaying, by the terminal, pseudo code matching the user's interaction on an expression window of the expression view when the user clicks the interaction button.

Fig. 3

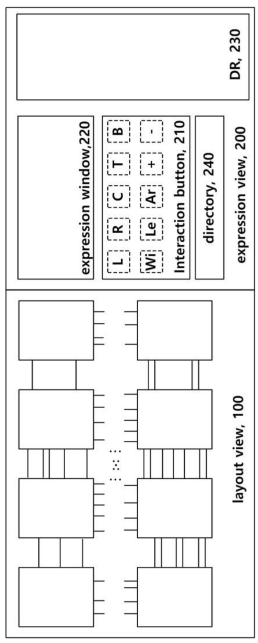


EP 4 708 107 A1

## Description

[Technical Field]

The present disclosure relates generally to a user interface method of a semiconductor design program and an operation device therefor.

[Background Art]

Semiconductor circuit design methods include a method of designing a layout using a generator. The generator receives parameters of a circuit from a designer and automatically generates a layout complying design rules and having sizes matching the input parameters. That is, when the generator is used, circuits of various sizes and designs can be quickly designed and manufactured for various different technology nodes after one task of coding.

Because a circuit design method using a generator supports a hierarchical design, it is possible to efficiently perform work by simply designing a generator of a unit cell and thereafter allocating a previously developed generator as a generator of a sub-cell when a complex cell is designed. Such a generator-based layout design is effectively used in semiconductor circuits requiring high-performances, e.g., circuits operating at high speeds, circuits requiring low power, etc.

[Disclosure]

[Technical Problem]

A process of developing a generator for automatically generating a layout according to the related art requires complex coding. A designer should express a width, height, length, physical layer information, etc., which are design specifications of a layout, using variables so that a layout generator may satisfy complicated design rules for the fabrication process.

However, in order to use variables of a specific layout object, the name of the layout object should be memorized to access data. Because a complex layout includes a very large number of layout objects, it is difficult for a designer to memorize all the names of the layout objects to access data. Therefore, the designer should repeatedly compare the layout object, written in complex code, with the layout tool which visualize layout, and find the names of the variables to modify a layout object.

The problem of the related art may become worse in a complex cell layout having a deep hierarchical structure. This is because the names of layout objects of a higher hierarchy layer are also required to access a specific layout object of a lower hierarchy layer. Therefore, the names of objects to be referenced by the designer increase greatly, thus greatly increasing a time required to design the generator.

The present disclosure is intended to solve the problems of the related art. The present disclosure is directed to a method of providing a simplified interface for facilitating a process of converting an already designed layout of a semiconductor circuit into a its generator.

[Technical Solution]

An embodiment of the present disclosure provides an operation device for performing a user interface method of a semiconductor design program, the operation device including at least one processor, and a memory storing one or more programs executable by the at least one processor, in which the at least one processor executes the one or more programs to perform the user interface method including displaying, by a terminal. performing the semiconductor design program, an interaction button for displaying an interaction to be performed by a user in a layout view and an expression view, the layout view displaying a layout being converted into a generator, and displaying, by the terminal, pseudo code matching the user's interaction on an expression window of the expression view when the user clicks the interaction button.

According to an aspect of the present embodiment, the layout to be converted into the generator may have a hierarchical structure, and when a user selects a lower hierarchy layer, the terminal may display a layout of the lower hierarchy layer in the layout view.

According to an aspect of the present embodiment, when the user clicks an interaction button for the lower hierarchy layer, the displaying of the pseudo code may include generating, by the terminal, the body of pseudo code which expresses hierarchical structure of the layer and displaying the pseudo code on the expression window.

According to an aspect of the present embodiment, the layout to be converted into the generator may have a hierarchical structure, and the terminal may display a layout of the lower hierarchy layer in a layout view displaying a sub-cell in an additional window.

According to an aspect of the present embodiment, the interaction button may display an interaction for obtaining pseudo code representing coordinates of a center of each of instances displayed in the layout view, coordinates of a left end of each of the instances, coordinates of a right end of each of the instances, coordinates of a top end of each of the instances, and coordinates of a bottom end of each of the instances.

According to an aspect of the present embodiment, the interaction button may display an interaction for obtaining pseudo code representing coordinates of an upper left vertex of a quadrangle including an instance displayed in the layout view, coordinates of a lower left vertex of the quadrangle, coordinates of an upper right vertex of the quadrangle, coordinates of a lower right vertex of a quadrangle, coordinates of a left side of the quadrangle, coordinates of a right side of the quadrangle, coordinates of a top side of the quadrangle, coordinates of a bottom side of the quadrangle, and coordinates of a midpoint of the quadrangle.

According to an aspect of the present embodiment, the interaction button may display an interaction for obtaining pseudo code representing a length, width, and area of a quadrangle including an instance displayed in the layout view.

According to an aspect of the present embodiment, the interaction button may include arithmetic operation buttons.

According to an aspect of the present embodiment, the expression view may further display a design rule (DR) window displaying design rule parameters for design of the semiconductor.

According to an aspect of the present embodiment, the expression view may further include a workspace for storing results of work conducted by the designer.

[Advantageous Effects]

According to present embodiment, the designer can obtain information through the layout and interaction buttons without needing to memorize all instance names contained in the semiconductor circuit to be converted into a generator, thereby providing the advantage of improved productivity.

[Description of Drawings]

FIG. 1 is a flowchart of an overview of a user interface method of a program for converting a semiconductor circuit into a generator according to an embodiment of the present disclosure;

FIG. 2 is a block diagram of an overview of an operation device that performs a user interface method of a semiconductor design program;

FIG. 3 is a diagram illustrating a state in which a layout view and an expression view are displayed on an outputter of an operation device;

FIG. 4 is a diagram illustrating a state in which a layout view is displaying a layout of a semiconductor chip to be converted into a generator

FIG. 5 is a diagram illustrating a state in which a resistor of a resistor unit, which is a sub-cell of a resistor bank, is selected and activated by a user;

FIG. 6 is a diagram illustrating a state in which a poly resistor, which is a sub-cell of a resistor unit that is an instance selected by a user, is activated; and

FIG. 7 is a diagram illustrating a formula of the coordinates of the center of an instance NMOS2 with respect to the center of an instance NMOS1.

[Modes of the Invention]

Hereinafter, embodiments will be described in detail with reference to the accompanying drawings. FIG. 1 is a flowchart of an overview of a user interface method of a semiconductor design program according to an embodiment of the present disclosure. Referring to FIG. 1, the user interface method includes displaying, by a terminal that performs a semiconductor design program, an interaction button for displaying an interaction to be performed by a user in a layout view displaying a layout of a semiconductor to be converted into a generator and an expression view (S100), and displaying, by the terminal, pseudo code matching the user’s interaction on an expression window of the expression view when the user clicks the interaction button (S200).

FIG. 2 is a block diagram of an overview of an operation device that performs a user interface method of a semiconductor design program. FIG. 2 is a diagram illustrating an overview of an operation device 1 that performs a user interface method of a semiconductor design program according to the present embodiment. Referring to FIG. 2, the operation device 1 according to the present embodiment includes an inputter 21, an outputter 22, a processor 25, a memory 24, and a data storage 23. The operation device 1 of FIG. 2 is only an example and thus not all blocks shown in FIG.

2 are essential components, and in another embodiment, some blocks may be added to, modified in, or deleted from the operation device 1. The operation device 1 may be implemented as a computing device for performing a user interface method, and each component included in the operation device 1 may be implemented as a separate software device or a separate hardware device associated with software.

The operation device 1 performs a user interface method including displaying a layout of a semiconductor circuit that is being converted into a generator in a layout view (100) and displaying an interaction button (210) for displaying an interaction to be performed by a user in an expression view (200) (S100), and displaying pseudo code matching the user's interaction on an expression window of the expression view (200) when the user clicks the interaction button (210) (S200), the user interface method being performed by a terminal that performs the semiconductor design program.

The inputter 21 is a means for receiving an interaction input or the like from a user. For example, the inputter 21 may include an input means, such as a keyboard or a mouse, for directly receiving an interaction from a user, and an input means for receiving a touch input from a user through a touch panel on the outputter 22 or the like. Through the inputter 21, various types of signals or data may be received in association with the processor 25 or data may be directly obtained in association with an external device and transmitted to the processor 25. The inputter 21 may be a device or a server for inputting or receiving log information, various condition information, or a control signal but is not necessarily limited thereto.

The outputter 22 may be a means for displaying information, such as a layout view, an expression view, and an interaction view, in association with the processor 25. The outputter 22 may display various types of information through a display (not shown), a speaker or the like included in the operation device 1 to output information but is not limited thereto.

The processor 25 performs at least one instruction or program stored in the memory 24. The processor 25 according to the present embodiment calculates data for performing each operation on the basis of data obtained from the inputter 21 or the data storage 23.

The memory 24 includes at least one instruction or program executable by the processor 25. The memory 24 may fetch and store instructions or a program for processing data stored in the data storage 23. The memory 24 may store a result of performing each operation, related values such as an intermediate value, etc.

The data storage 23 is a general data structure implemented in a storage space (hard disk or memory) of a computer system using a data storage management program (DBMS). Data may be freely retrieved (extracted) from, deleted from, edited in or added to the data storage 23. In an embodiment, the data storage 23 may store instructions compiled to allow a user interface method according to the present embodiment to be executed and driven by the processor 25. The memory 24 may fetch the instructions in response to a request from the processor 25.

The data storage 23 according to the present embodiment may receive and store a user input and a user restriction condition provided through the inputter 21, and may provide stored data as necessary. The data storage 23 is described herein as being included in the operation device 1 but is not necessarily limited thereto and may be implemented as a separate data storage device.

FIG. 3 is a diagram illustrating a state in which a layout view 100 and an expression view 200 are displayed on an outputter 22 of an operation device 1. The layout view 100 may be a window for displaying a layout of a semiconductor circuit that is being converted into a generator by a designer. In general, semiconductor circuits are designed in a hierarchical structure. Therefore, semiconductor circuits to be converted into generators may be hierarchically displayed in the layout view 100. In an embodiment, when a semiconductor circuit includes a plurality of instances as in the embodiment of FIG. 3, the layout view 100 may display a plurality of instances forming a hierarchical structure of semiconductor circuits.

In an embodiment, instances include functional blocks designed by a semiconductor circuit designer, sub-blocks that are sub-components in each of the functional blocks, and unit elements constituting the sub-blocks, and may be hierarchically configured up to a lowest level as described above.

The expression view 200 may display interaction buttons 210 for displaying an interaction to be performed by a user with respect to various instances displayed in the layout view 100. In an embodiment, information including pseudo code of an instance designated by a user may be formed and displayed on the expression window 220 through the interaction buttons 210.

In the illustrated embodiment, the interaction buttons 210 may include a button L for obtaining pseudo code representing the coordinates of a left end of an instance designated by a user, a button C for obtaining pseudo code representing the coordinates of the center of the instance, a button R for obtaining pseudo code representing the coordinates of a right end of the instance, a button T for obtaining pseudo code representing the coordinates of a top end of the instance, and a button B for obtaining pseudo code representing the coordinates of a bottom end of the instance.

The interaction buttons 210 may include a button Le for obtaining pseudo code representing the length of a quadrangle including an instance designated by a user, a button Wi for obtaining pseudo code representing the width of the quadrangle, and a button Ar for obtaining pseudo code representing the area of the quadrangle. The interaction buttons 210 may further include +, -, ×, and ÷ buttons for performing arithmetic operations and interaction buttons 210 may further include buttons for performing mathematic operations.

In an embodiment not shown, interaction buttons may be displayed in a layout view, and may include buttons for obtaining pseudo codes representing the coordinates of an upper left vertex, the coordinates of a lower left vertex, the coordinates of an upper right vertex, the coordinates of a lower right vertex, the coordinates of a midpoint on a left side of the quadrangle, the coordinates of a midpoint on a right side of the quadrangle, the coordinates of a midpoint on an upper side of the quadrangle, the coordinates of a midpoint on a lower side of the quadrangle, and the coordinates of a midpoint.

In an embodiment not shown, interaction buttons may include a button for displaying functions required to design a layout. For example, buttons may include buttons for obtaining a function for calculating the distance between two layout objects, a function for calculating the number of vias or contacts satisfying design rules for a given area, and a function for obtaining the total number of layout objects expressed as an array.

The expression view 200 may include a design rule (DR) window 230 displaying semiconductor design rules restricting layout designs. In an embodiment, when instances include a plurality of transistors, the expression view 200 may display pseudo code which represents design rules for design of the semiconductor and design rules that describes various layout design restrictions, such as the minimum distance between metal interconnections included in the transistors, the minimum distance between diffusion physical layers included in the transistors, and the like.

When a user selects one instance in the layout view 100 and thereafter selects the button C for obtaining the pseudo code representing the coordinates of the center of the instance from among the interaction buttons 210, the pseudo code corresponding to the coordinates of the center of the selected instance is displayed on the expression window 220 of the expression view 200.

A case in which pseudo code representing the coordinates of a right end of an instance op_layer(OL) included in a sub-cell of a sub-cell of a layout that is being converted into a generator will be described with reference to FIGs. 4 to 6 below. FIG. 4 is a diagram illustrating a layout of a semiconductor circuit that is being converted into a generator. Referring to FIG. 4, a plurality of instances are displayed in a layout view 100. A user selects a desired sub-cell instance in the layout view 100 of FIG. 4. FIG. 4 illustrates an example in which a user selects a resistor unit RU in the layout view 100. The instance selected by the user is drawn by a thick line in FIG. 4.

In the layout view 100 of FIG. 4, a state in which the resistor unit RU that is an sub-cell instance selected by the user is activated is shown. A user may obtain pseudo code associated with desired information of the sub-cell instance by selecting the corresponding button from among the interaction buttons 210 described above. For example, a user may select button C to obtain pseudo code representing the coordinates of the center of the resistor unit RU. An additional example is that a user may select the button R to obtain pseudo code representing the coordinates of the right end of the resistor unit RU.

FIG. 5 is a diagram illustrating a state in which a layout view 101 displays a sub-cell instance selected by a user in FIG. 4. Referring to FIGs. 4 and 5, in an embodiment, when a user selects a sub-cell instance, which is a resistor unit RU in FIG. 4, an operation device automatically activates the selected sub-cell. In another embodiment, when a user selects an instance (FIG. 4) and thereafter selects a button (not shown) to open a new layout view 101 of the selected sub-cell, the layout view 101 of the selected sub-cell, which is a resistor unit RU in FIG. 4, is newly opened and the sub-cell instance selected by the user is displayed (FIG. 5).

However, when information that the user wants to obtain is included in a polyresistor PR included in the resistor unit RU in FIG. 5, the user selects the polyresistor PR that is a target object in the layout view 101 in FIG. 5. the operation device activates and the selected sub-cell is opened in a new window and the polyresistor PR selected by the user is displayed. In another embodiment, when a user selects an instance and thereafter selects a button (not shown) to open the layout view 102 of the selected polyreisstor PR sub-cell instance, the layout view 102 of the selected sub-cell is opened in a new window and the polyresistor PR selected by the user is displayed.

FIG. 6 is a diagram illustrating a state in which a layout view 102 displays a polyreisstor PR sub-cell instance selected by a user. The layout view 102 of the selected sub-cell instance is newly opened and displays the polyresistor PR that is the sub-cell instance selected by the user. The user may select a desired sub-cell instance op_layer (OL), and select the button R to obtain pseudo code representing the coordinates of the right end of the instance op_layer (OL).

The pseudo code for obtaining the coordinates of the right end of the sub-cell instance op_layer (OL) selected by the user is displayed on an expression window 220. The pseudo code displayed on the expression window 220 shows instances according to the hierarchical structure and codes according to interaction buttons that is.

The pseudo code formed as described above and results of work conducted by a designer may be stored in a directory 240 of the expression view 200, and a worker may use previous work results stored in the directory 240.

Hereinafter, an example in which the coordinates of the center of an instance are found using another instance displayed in a layout view will be described with reference to FIG. 7 below. FIG. 7 is a diagram illustrating an expression of the coordinates of the center of an instance NMOS2 with respect to an instance NMOS1. Variables of the coordinates of the center of the NMOS1 indicated by a white X may be expressed as center(NMOS1). In the instance NMOS1 that has an hierarchical sub-layer, an OD layer, pseudo code width(NMOS1, OD) describing a width of the OD layer of the instance NMOS1 may be obtained by activating a diffusion physical layer OD in a layout view and selecting the button Wi from among the interaction buttons 210 through the above-described process. Similarly, pseudo code width(NMOS2, OD) calculating a width of an OD layer of the instance NMOS2 may be obtained.

There are design rules required for semiconductor circuit layout design. As described above, the distance between metal interconnections, the distance between diffusion physical layers of transistors, and the like are limited by the design rules of process technology. In the embodiment of FIG. 7, a minimum distance between a diffusion physical layer of the instance NMOS1 and a diffusion physical layer of the instance NMOS2 is also limited by the design rules of process technology, and may be expressed as OD_dr.

Therefore, the coordinates (X2, Y2) of the center of the instance NMOS2 may be expressed in the form of pseudo code using the above-described variables as in Equation 1 below.

[X2, Y2] = center(NMOS1)+[width(NMOS1, OD)/2, 0]+[OD_drc, 0]+[width(NMOS1, OD)/2, 0] [Equation 1]

In the related art, a designer memorizes all the names of instances and performs coding using the names. Therefore, when a hierarchical structure is complicated, a large amount of time is required to perform coding, thus reducing productivity.

However, according to the present embodiment, there is no need for a designer to memorize the name of each object as described above, and a formula can be easily completed by simply selecting a desired layout object in a layout view and clicking a desired button or the like in an expression view.

According to an embodiment of the present disclosure, it is possible to obtain information through a layout and an interaction button without having to memorize all the names of instances included in a semiconductor circuit to be converted into a generator by a designer, thereby improving productivity.

Although the embodiments illustrated in the drawings have been described above to help the present disclosure be understood, these embodiments are only examples and it will be apparent to those of ordinary skill in the art that various modifications may be made and other equivalent embodiments are derivable from the embodiments. Therefore, the scope of the present disclosure should be defined by the appended claims.

## Claims

**1.** A user interface method of a semiconductor design program, comprising:

displaying, by a terminal performing the semiconductor design program, an interaction button for displaying an interaction to be performed by a user in a layout view and an expression view, the layout view displaying a layout of a semiconductor to be converted into a generator; and

displaying, by the terminal, pseudo code matching the user's interaction on an expression window of the expression view when the user clicks the interaction button.

**2.** The user interface method of claim 1, wherein the layout of the semiconductor to be converted into the generator has a hierarchical structure, and
when a user selects a lower layer, the terminal displays a layout of the lower layer in the layout view.

**3.** The user interface method of claim 2, wherein, when the user clicks an interaction button for the lower layer, the displaying of the pseudo code comprises generating, by the terminal, the pseudo code for the hierarchical structure and displaying the pseudo code on the expression window.

**4.** The user interface method of claim 2, wherein the layout of the semiconductor to be converted into the generator has the hierarchical structure, and
the terminal displays the layout of the lower layer in a layout view representing a sub-cell which is an additional window.

**5.** The user interface method of claim 1, wherein the interaction button displays an interaction for obtaining pseudo code representing coordinates of a center of each of instances displayed in the layout view, coordinates of a left end of each of the instances, coordinates of a right end of each of the instances, coordinates of a top end of each of the instances, and coordinates of a bottom end of each of the instances.

**6.** The user interface method of claim 1, wherein the interaction button displays an interaction for obtaining pseudo code representing coordinates of an upper left vertex of a quadrangle including an instance displayed in the layout view, coordinates of a lower left vertex of the quadrangle, coordinates of an upper right vertex of the quadrangle, coordinates of a lower right vertex of a quadrangle, coordinates of a left side of the quadrangle, coordinates of a right side of the quadrangle, coordinates of a top side of the quadrangle, coordinates of a bottom side of the quadrangle, and coordinates of a midpoint of the quadrangle.

**7.** The user interface method of claim 1, wherein the interaction button displays an instance for obtaining pseudo code representing a length, width, and area of a quadrangle including an instance displayed in the layout view.

**8.** The user interface method of claim 1, wherein the interaction button comprises arithmetic operation buttons.

**9.** The user interface method of claim 1, wherein the expression view further displays a design rule (DR) window displaying design rule parameters for design of the semiconductor.

**10.** The user interface method of claim 1, wherein the expression view further comprises a workspace for storing results of work conducted by the designer.

**11.** The user interface method of claim 1, wherein the layout view displays a layout instance which is a target of the pseudo code displayed on the expression window of the expression view.

**12.** The user interface method of claim 1, wherein the interaction button comprises one of:

a button for calling a function of calculating a distance between different layout objects;
a button for calling a function of calculating the number of vias or contacts that satisfy design rules for a given area; and
a button for displaying a function of calculating a total number of layout objects expressed in an array.

**13.** An operation device for performing a user interface method of a semiconductor design program, the operation device comprising:

at least one processor; and
a memory storing one or more programs executable by the at least one processor,
wherein the at least one processor executes the one or more programs to perform the user interface method, wherein the user interface method comprises:

displaying, by a terminal performing the semiconductor design program, an interaction button for displaying an interaction to be performed by a user in a layout view and an expression view, the layout view displaying a layout of a semiconductor to be converted into a generator; and
displaying, by the terminal, pseudo code matching the user's interaction on an expression window of the expression view when the user clicks the interaction button.

**14.** The operation device of claim 13, wherein the layout of the semiconductor to be converted into the generator has a hierarchical structure, and
when a user selects a lower layer, the terminal displays a layout of the lower layer in the layout view.

**15.** The operation device of claim 14, wherein, when the user clicks an interaction button for the lower layer, the displaying of the pseudo code comprises generating, by the terminal, the pseudo code for the hierarchical structure and displaying the pseudo code on the expression window.

**16.** The operation device of claim 14, wherein the layout of the semiconductor to be converted into the generator has a hierarchical structure, and
the terminal displays a layout of the lower layer in a layout view displaying a sub-cell which is an additional window.

**17.** The operation device of claim 13, wherein the interaction button displays an interaction for obtaining pseudo code representing coordinates of a center of each of instances displayed in the layout view, coordinates of a left end of each of the instances, coordinates of a right end of each of the instances, coordinates of a top end of each of the instances, and coordinates of a bottom end of each of the instances.

**18.** The operation device of claim 13, wherein the interaction button displays an interaction for obtaining pseudo code representing coordinates of an upper left vertex of a quadrangle including an instance displayed in the layout view, coordinates of a lower left vertex of the quadrangle, coordinates of an upper right vertex of the quadrangle, coordinates of a lower right vertex of a quadrangle, coordinates of a left side of the quadrangle, coordinates of a right side of the quadrangle, coordinates of a top side of the quadrangle, coordinates of a bottom side of the quadrangle, and coordinates of a midpoint of the quadrangle.

**19.** The operation device of claim 13, wherein the interaction button displays an interaction for obtaining pseudo code representing a length, width, and area of a quadrangle including an instance displayed in the layout view.

**20.** The operation device of claim 13, wherein the interaction button comprises arithmetic operation buttons.

**21.** The operation device of claim 13, wherein the expression view further displays a design rule (DR) window displaying design rule parameters for design of the semiconductor.

**22.** The operation device of claim 13, wherein the expression view further comprises a workspace for storing results of work conducted by the designer.

**23.** The operation device of claim 13, wherein the layout view displays a layout instance which is a target of the pseudo code displayed on the expression window of the expression view.

**24.** The operation device of claim 13, wherein the interaction button comprises one of:

a button for calling a function of calculating a distance between different layout objects;
a button for calling a function of calculating the number of vias or contacts that satisfy design rules for a given area; and
a button for displaying a function of calculating a total number of layout objects expressed in an array.

Fig. 1

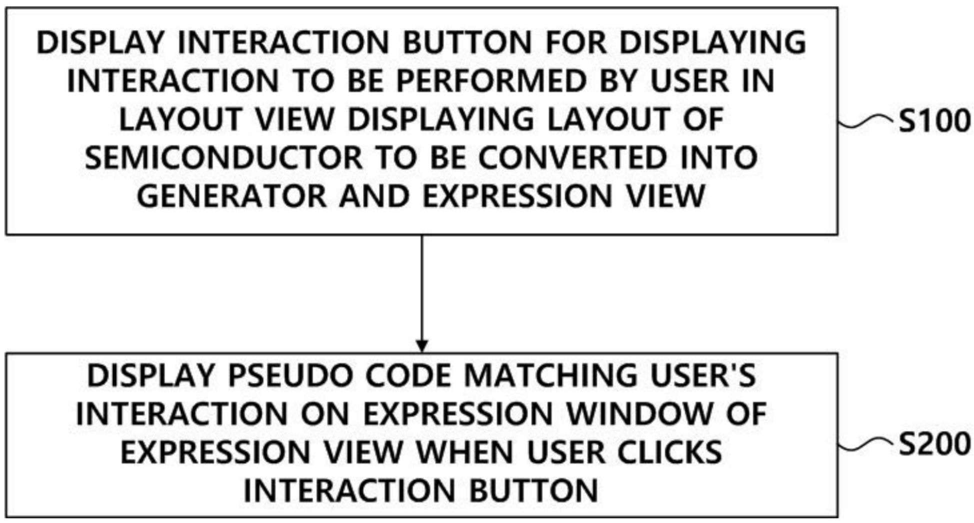
DISPLAY INTERACTION BUTTON FOR DISPLAYING INTERACTION TO BE PERFORMED BY USER IN LAYOUT VIEW DISPLAYING LAYOUT OF SEMICONDUCTOR TO BE CONVERTED INTO GENERATOR AND EXPRESSION VIEW
S100
DISPLAY PSEUDO CODE MATCHING USER'S INTERACTION ON EXPRESSION WINDOW OF EXPRESSION VIEW WHEN USER CLICKS INTERACTION BUTTON
S200

Fig. 2

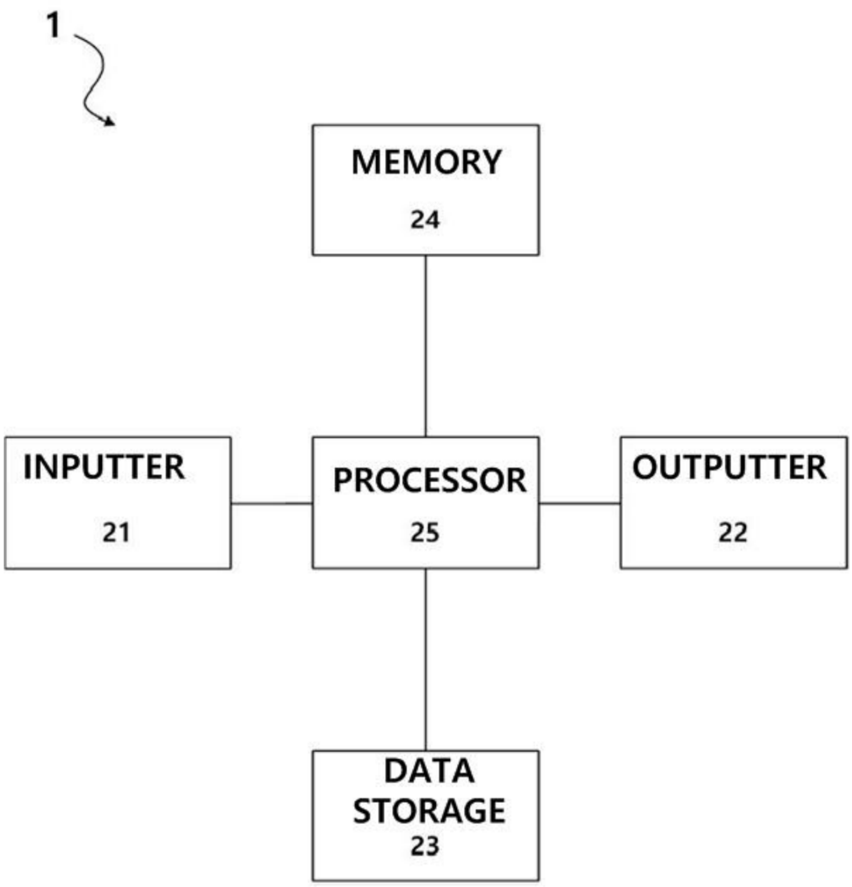
1
MEMORY
24
INPUTTER
21
PROCESSOR
25
OUTPUTTER
22
DATA
STORAGE
23

Fig. 3

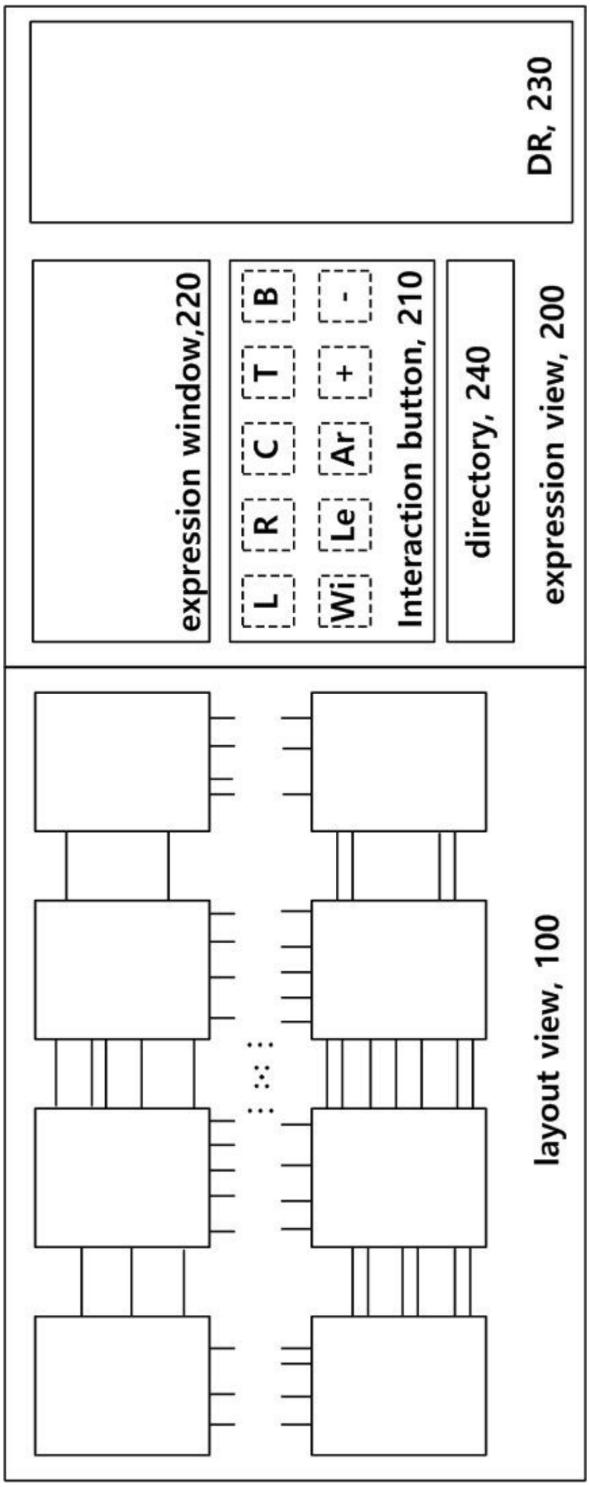
DR, 230
expression window,220
L
R
C
T
B
Wi
Le
Ar
+
-
Interaction button, 210
directory, 240
expression view, 200
layout view, 100

Fig. 4

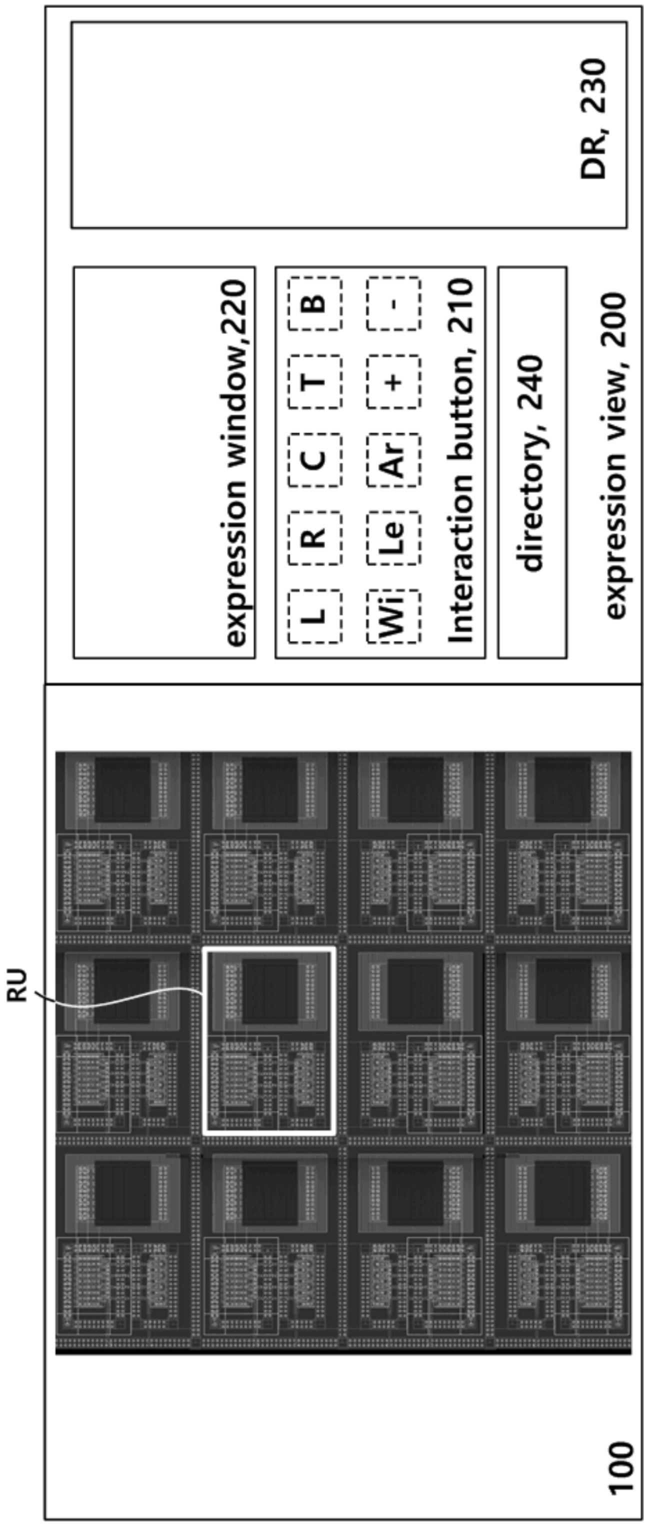
DR, 230
expression window,220
L
R
C
T
B
Wi
Le
Ar
+
-
Interaction button, 210
directory, 240
expression view, 200
RU
100

Fig. 5

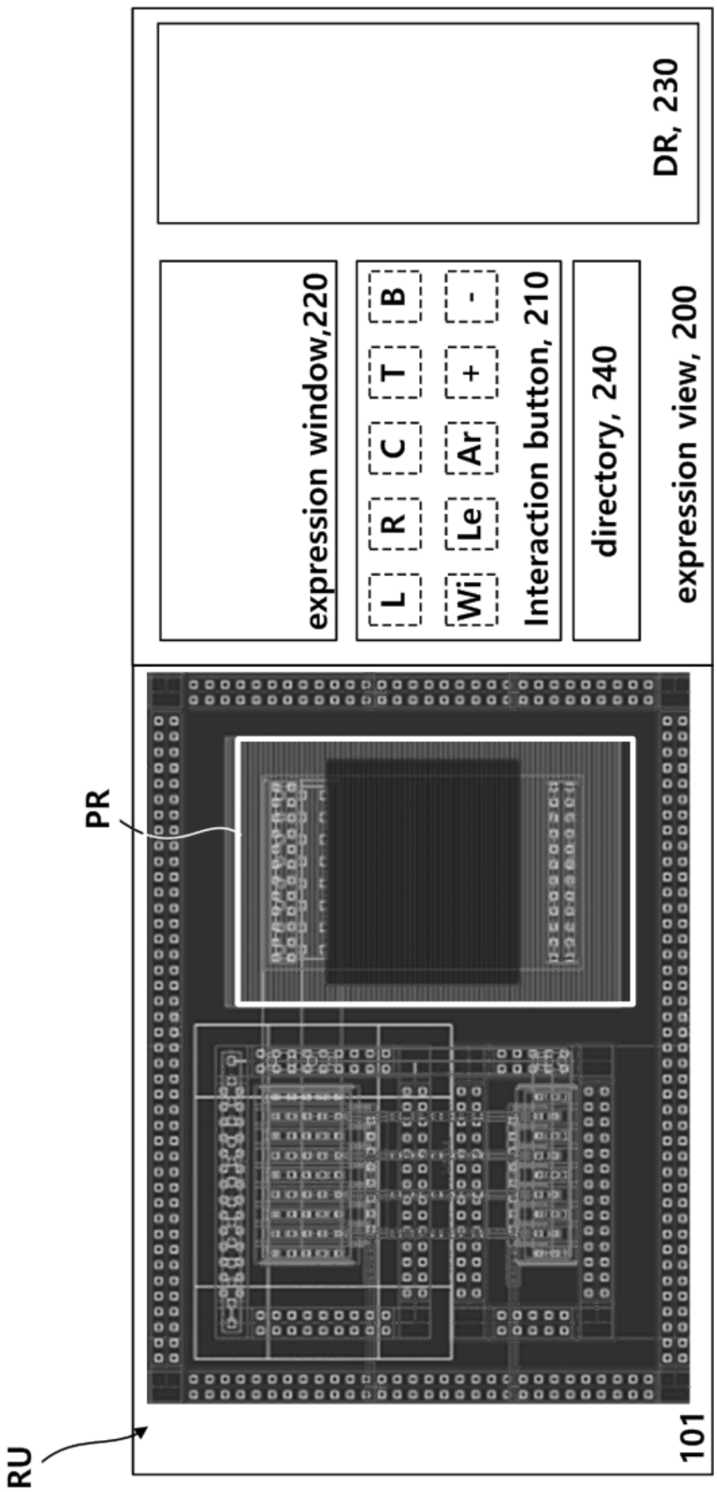
DR, 230
expression window,220
L
R
C
T
B
Wi
Le
Ar
+
-
Interaction button, 210
directory, 240
expression view, 200
PR
RU
101

Fig. 6

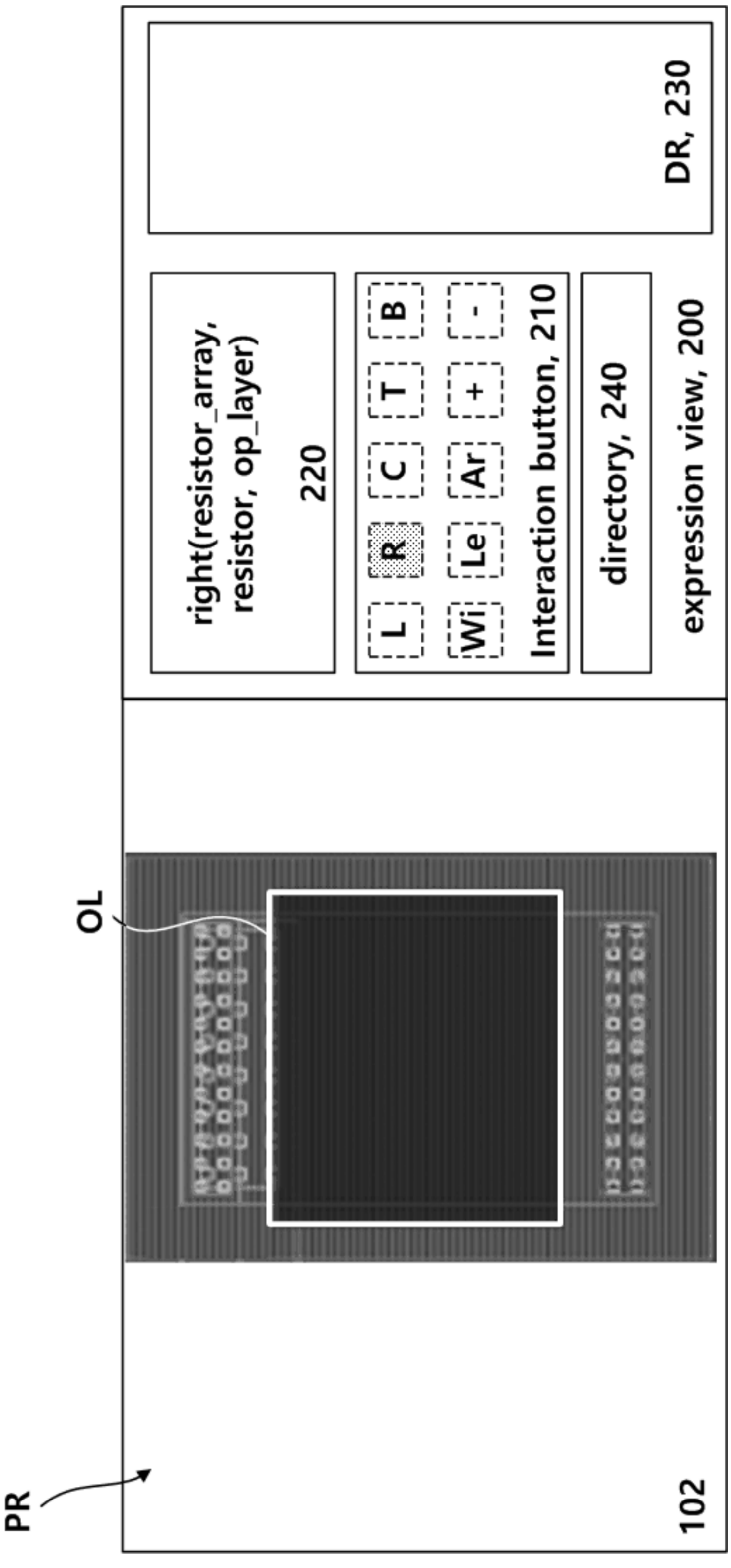
DR, 230
right(resistor_array, resistor, op_layer)
220
L
R
C
T
B
Wi
Le
Ar
+
-
Interaction button, 210
directory, 240
expression view, 200
OL
PR
102

Fig. 7

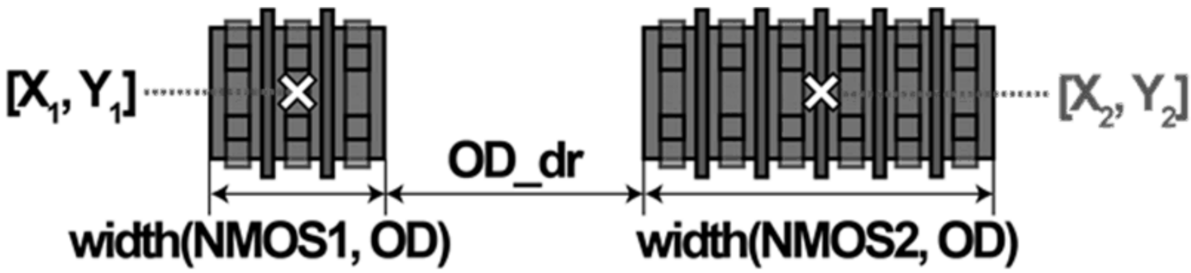

**INTERNATIONAL SEARCH REPORT**

International application No. **PCT/KR2023/014659**

**A. CLASSIFICATION OF SUBJECT MATTER**

**G06F 30/12**(2020.01)i; **G06F 30/392**(2020.01)i; **G06F 3/048**(2006.01)i; **G06F 9/451**(2018.01)i

According to International Patent Classification (IPC) or to both national classification and IPC

**B. FIELDS SEARCHED**

Minimum documentation searched (classification system followed by classification symbols)

G06F 30/12(2020.01); G05B 19/4068(2006.01); G06F 17/50(2006.01); G06F 3/0481(2013.01); G06F 3/0482(2013.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 반도체 설계(semiconductor design), 레이아웃 뷰(layout view), 표현 뷰(expression view), 인터랙션 버튼(interaction button), 슈도 코드(pseudo code)

**C. DOCUMENTS CONSIDERED TO BE RELEVANT**

| Category* | Citation of document, with indication, where appropriate, of the relevant passages | Relevant to claim No. |
|---|---|---|
| Y | US 2018-0089360 A1 (MITUTOYO CORPORATION et al.) 29 March 2018 (2018-03-29) See paragraphs [0004] and [0059]. | 1-24 |
| Y | US 2019-0302732 A1 (SYNOPSYS, INC.) 03 October 2019 (2019-10-03) See claim 1; and figures 7A-7B. | 1-24 |
| Y | US 8843865 B2 (TAI, Philip H. et al.) 23 September 2014 (2014-09-23) See claims 1 and 3. | 2-4,14-16 |
| Y | US 2022-0050558 A1 (XANO, INC.) 17 February 2022 (2022-02-17) See paragraphs [0021] and [0040]. | 5-8,11-12,17-20,23-24 |
| Y | JP 2003-016115 A (TOKYO ELECTRON LTD.) 17 January 2003 (2003-01-17) See claim 1. | 9-10,21-22 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **26 January 2024** | **26 January 2024** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

International application No.
**PCT/KR2023/014659**

### C. DOCUMENTS CONSIDERED TO BE RELEVANT

| Category* | Citation of document, with indication, where appropriate, of the relevant passages | Relevant to claim No. |
|---|---|---|
| A | US 2018-0144085 A1 (INTERNATIONAL BUSINESS MACHINES CORPORATION) 24 May 2018 (2018-05-24)<br>See paragraphs [0016]-[0044]; claims 1-8; and figures 2 and 4. | 1-24 |

Form PCT/ISA/210 (second sheet) (July 2022)

**INTERNATIONAL SEARCH REPORT**
**Information on patent family members**

International application No.
**PCT/KR2023/014659**

| Patent document cited in search report | Publication date (day/month/year) | Patent family member(s) | Publication date (day/month/year) |
|---|---|---|---|
| US 2018-0089360 A1 | 29 March 2018 | US 10990075 B2 | 27 April 2021 |
| US 2019-0302732 A1 | 03 October 2019 | US 10295988 B2 | 21 May 2019 |
| | | US 10990077 B2 | 27 April 2021 |
| | | US 2018-0059643 A1 | 01 March 2018 |
| US 8843865 B2 | 23 September 2014 | US 2013-0227503 A1 | 29 August 2013 |
| US 2022-0050558 A1 | 17 February 2022 | US 11481089 B2 | 25 October 2022 |
| | | US 2023-0018802 A1 | 19 January 2023 |
| JP 2003-016115 A | 17 January 2003 | None | |
| US 2018-0144085 A1 | 24 May 2018 | US 10372865 B2 | 06 August 2019 |

Form PCT/ISA/210 (patent family annex) (July 2022)